# EUROPEAN PATENT APPLICATION

(11) **EP 4 763 806 A1**
(43) Date of publication of application: **24.06.2026**
(21) Application number: 25222288.0
(22) Date of filing: 10.12.2025
(51) Int. Cl.: C01G 53/54, H01M 4/525

(54) **BATTERY CATHODE MATERIAL, ITS PRECURSOR, METHOD FOR ITS MANUFACTURE, AND LITHIUM-ION BATTERY**

(30) Priority: 11.12.2024 TW 113148216
(71) Applicant: Hon Hai Precision Industry Co., Ltd., 236038 New Taipei City (TW); SolidEdge Solution Inc., Hsinchu City 300094 (TW)
(72) Inventor: HUNG, Chen-Tsung, 300094 Hsinchu City (TW); CHANG, Tseng-Lung, 300094 Hsinchu City (TW)
(74) Representative: Mewburn Ellis LLP

(57) **Abstract**

The present disclosure provides a battery cathode material, including a lithium nickel manganese oxide powder, a crystal structure of the lithium nickel manganese oxide powder is single crystal, a particle size span of the lithium nickel manganese oxide powder is less than 5, and the particle size span is (D₉₀-D₁₀)/D₅₀ from a particle size distribution.

## Description

### BACKGROUND

### Field of Disclosure

The present disclosure relates to a battery cathode material, its precursor, and a method for manufacturing the same, as well as a lithium-ion battery including the battery cathode material.

### Description of Related Art

A good battery cathode material should possess advantages such as high energy density, structural stability, and long cycle life. However, conventional methods for manufacturing battery cathode materials have numerous drawbacks and often fail to produce satisfactory cathode materials. For example, the solid-state reaction method requires a high processing temperature, resulting in poor uniformity of the battery cathode material obtained. The sol-gel method requires a large amount of organic chelating agents and yields low quantities of battery cathode material. The co-precipitation method requires the addition of precipitating agents, but it may not enable different cations to precipitate simultaneously from the solution, leading to poor uniformity of the resulting cathode material. Moreover, the process of washing impurities in the co-precipitation method may prevent the cathode material from achieving the desired stoichiometry, making it difficult to obtain high-purity cathode material.

Given the limitations of current technologies, there is a need for a novel method and related apparatus for manufacturing battery cathode materials. Such a method should not only feature a simple process and low cost but also produce high-quality battery cathode materials, enabling the formation of batteries with excellent properties.

### SUMMARY

The present disclosure provides a battery cathode material, including a lithium nickel manganese oxide powder. The crystal structure of the lithium nickel manganese oxide powder is single crystal, the particle size span of the lithium nickel manganese oxide powder is less than 5, and the particle size span is (D₉₀-D₁₀)/D₅₀ from a particle size distribution.

In some embodiments, the particle size of the lithium nickel manganese oxide powder is between 0.5 µm and 15 µm.

In some embodiments, the single crystal of the lithium nickel manganese oxide powder is a cubic crystal system with a {111} crystal plane and has an octahedral shape.

In some embodiments, in an X-ray diffraction pattern of the lithium nickel manganese oxide powder, a ratio of a first intensity at a first diffraction position to a second intensity at a second diffraction position is less than 0.5. The 2θ value of the first diffraction position is between 41° and 47°, and the 2θ value of the second diffraction position is between 15° and 22°.

In some embodiments, in the X-ray diffraction pattern of the lithium nickel manganese oxide powder, the first intensity at the first diffraction position is less than a third intensity at a third diffraction position, and the 2θ value of the third diffraction position is between 35.5° and 37.5°.

In some embodiments, the lithium nickel manganese oxide powder is represented by the formula LiₓNi_{y}A_{z}Mn_{2-y-z}O₄, where A is Al, Ti, Zr, Cr, Fe, Nb, or Sb; x is between 0.99 and 1.10; y is between 0.40 and 0.50; and z is between 0 and 0.1.

The present disclosure also provides a lithium-ion battery, including a cathode, an anode, and an electrolyte located between the cathode and the anode. The cathode includes a metal electrode and the lithium nickel manganese oxide powder described above, in which the lithium nickel manganese oxide powder is disposed on the metal electrode.

The present disclosure further provides a precursor for a battery cathode material. The precursor includes a lithium nickel manganese oxide precursor powder, in which the lithium nickel manganese oxide precursor powder includes a mixture of a lithium source, a nickel source, and a manganese source. The particle size span of the lithium nickel manganese oxide precursor powder is less than 5, and the particle size span is (D₉₀-D₁₀)/D₅₀ from a particle size distribution.

In some embodiments, the particle size of the lithium nickel manganese oxide precursor powder is between 1 µm and 10 µm.

In some embodiments, the D₅₀ of the particle size distribution is between 2 µm and 8 µm.

In some embodiments, the molar ratio of lithium from the lithium source, nickel from the nickel source, and manganese from the manganese source in the lithium nickel manganese oxide precursor powder is 0.99-1.10:0.40-0.50:1.4-1.6.

In some embodiments, the lithium source includes Li₂CO₃, LiNO₃, Li₂C₂O₄, LiOH, or a combination thereof; the nickel source includes NiCO₃, Ni(NO₃)₂, NiC₂O₄, Ni(OH₎₂, or a combination thereof; and the manganese source includes MnCO₃, MnOOH, MnO₂, or a combination thereof.

In some embodiments, the particle size of the lithium source is between 100 nm and 1500 nm, the particle size of the nickel source is between 100 nm and 1500 nm, and the particle size of the manganese source is between 100 nm and 1500 nm.

In some embodiments, the particle size span of the lithium source is between 1.0 and 2.5, the particle size span of the nickel source is between 1.0 and 2.5, and the particle size span of the manganese source is between 1.0 and 2.5.

The present disclosure also provides a method for manufacturing a battery cathode material, including the following steps. A lithium nickel manganese oxide precursor liquid is spray-dried using an atomizer to form a lithium nickel manganese oxide precursor powder. The lithium nickel manganese oxide precursor powder is heated using a heater to form a lithium nickel manganese oxide powder, in which the crystal structure of the lithium nickel manganese oxide powder is single crystal, the particle size span of the lithium nickel manganese oxide powder is less than 5, and the particle size span is (D₉₀-D₁₀)/D₅₀ from a particle size distribution.

In some embodiments, the lithium nickel manganese oxide precursor liquid includes a lithium source, a nickel source, a manganese source, and water, in which the solid content of the lithium nickel manganese oxide precursor liquid is between 18 wt% and 40 wt%, and the apparent density of the lithium nickel manganese oxide precursor liquid is between 1.1 g/cm³ and 1.6 g/cm³.

In some embodiments, when the lithium nickel manganese oxide precursor liquid is spray-dried using the atomizer, the lithium nickel manganese oxide precursor liquid collides with a gas in the atomizer. The particle size of the lithium nickel manganese oxide powder is inversely proportional to the flow rate ratio of the gas to the lithium nickel manganese oxide precursor liquid, in which the flow rate ratio of the gas to the lithium nickel manganese oxide precursor liquid is between 3000 and 10000.

In some embodiments, the gas includes air or oxygen.

In some embodiments, when the lithium nickel manganese oxide precursor liquid is spray-dried using the atomizer, the lithium nickel manganese oxide precursor liquid is dried in the atomizer at a temperature between 100°C and 250°C.

In some embodiments, the temperature for heating the lithium nickel manganese oxide precursor powder is between 800°C and 1100°C, and the heating duration is between 8 hours and 16 hours.

### BRIEF DESCRIPTION OF THE DRAWINGS

Fig. 1A and Fig. 1B are, respectively, an electron microscope image and a schematic diagram of lithium nickel manganese oxide powder according to some embodiments of the present disclosure;
Fig. 2 is an X-ray diffraction (XRD) pattern of lithium nickel manganese oxide powder according to some embodiments of the present disclosure;
Fig. 3A is a cross-sectional schematic diagram of an apparatus for manufacturing battery cathode materials according to some embodiments of the present disclosure;
Fig. 3B is a top view schematic diagram of an apparatus for manufacturing battery cathode materials according to some embodiments of the present disclosure;
Fig. 4 is a flowchart illustrating a method for manufacturing battery cathode materials according to some embodiments of the present disclosure;
Fig. 5A and Fig. 5B are particle size distribution graphs according to some embodiments of the present disclosure;
Fig. 6A and Fig. 6B are electron microscope images of the third embodiment according to the present disclosure.
Fig. 7 is a graph of charge-discharge voltage versus capacity for a lithium-ion battery according to the third embodiment of the present disclosure;
Fig. 8 is a graph of charge-discharge capacity versus cycle number and coulombic efficiency versus cycle number for a lithium-ion battery according to the third embodiment of the present disclosure;
Fig. 9 is an electron microscope image of the fourth embodiment according to the present disclosure;
Fig. 10A and Fig. 10B are electron microscope images of the fifth embodiment according to the present disclosure;
Fig. 11A and Fig. 11B are electron microscope images of the sixth embodiment according to the present disclosure;
Fig. 12A and Fig. 12B are electron microscope images of the seventh embodiment according to the present disclosure; and
Fig. 13 is an X-ray diffraction (XRD) pattern of some comparative examples according to the present disclosure.

### DETAILED DESCRIPTION

The present disclosure provides a cathode material for batteries, which includes lithium nickel manganese oxide powder. The crystalline structure of the lithium nickel manganese oxide powder is single-crystal, with a particle size span of less than 5, where the particle size span is defined as (D₉₀-D₁₀)/D₅₀ in the particle size distribution. The lithium nickel manganese oxide powder described in the present disclosure is of high quality, featuring a single-crystal structure (understood by those skilled in the art to mean continuous and uninterrupted lattices without grain boundaries) and minimal particle size variation. Batteries using the lithium nickel manganese oxide powder of the present disclosure as cathode material exhibit excellent performance, such as a long cycle life (details provided below). The following describes the cathode material in detail based on several embodiments.

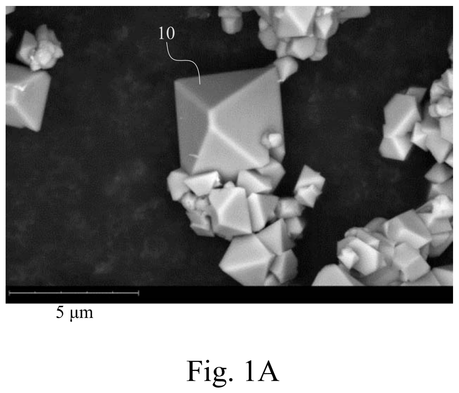

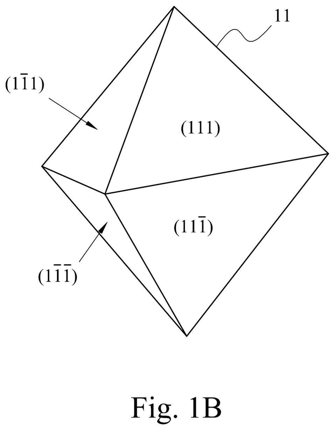

In some embodiments, the lithium nickel manganese oxide powder may optionally be doped with other elements, such as Al, Ti, Zr, Cr, Fe, Nb, or Sb. In some embodiments, the lithium nickel manganese oxide powder substantially excludes Co to enhance structural stability and avoid using cobalt, which is more toxic, expensive, and environmentally harmful. In some embodiments, the lithium nickel manganese oxide powder can be represented as LiₓNi_{y}A_{z}Mn_{2-y-z}O₄, where x is from 0.99 to 1.10, for example, 0.99, 1.00, 1.02, 1.05, 1.08, or 1.10; y is from 0.40 to 0.50, for example, 0.40, 0.42, 0.44, 0.46, 0.48, or 0.50; z is from 0 to 0.1, such as 0 (undoped); and A is Al, Ti, Zr, Cr, Fe, Nb, or Sb. In some embodiments, the single-crystal 11 of the lithium nickel manganese oxide powder 10 belongs to the cubic crystal system with {111} crystal planes, such as including the (111), (111), (111), and (11̅1̅) crystal planes, and has an octahedral shape, as illustrated in Fig. 1A and Fig. 1B. In some embodiments, the single-crystal of the lithium nickel manganese oxide powder substantially excludes crystals with {001} crystal planes, such as excluding the (100), (010), and (001) crystal planes.

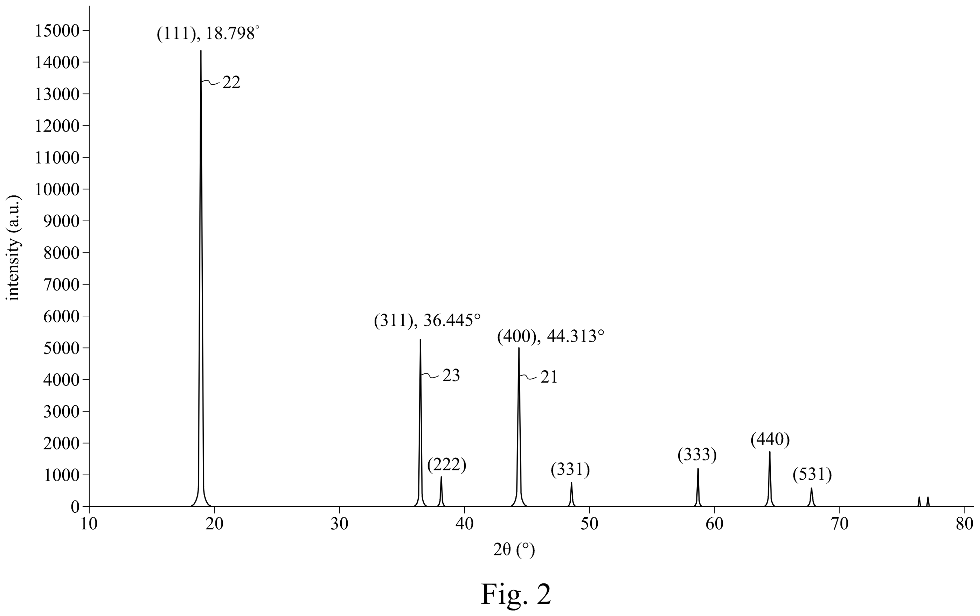

Referring to Fig. 2, which shows the X-ray diffraction (XRD) pattern of the lithium nickel manganese oxide powder (e.g., using Cu-Kα X-ray powder diffraction), in some embodiments, the ratio of the first intensity at the first diffraction position 21 to the second intensity at the second diffraction position 22 (i.e., the first intensity divided by the second intensity) is less than 0.5. The second diffraction position 22 corresponds to the position of the (111) crystal plane, with a 20 value between 15° and 22°, for example, 15°, 16°, 17°, 18°, 19°, 20°, 21°, or 22°. The first diffraction position 21 corresponds to the position of the (400) crystal plane, with a 20 value between 41° and 47°, for example, 41°, 42°, 43°, 44°, 45°, 46°, or 47°. A ratio of less than 0.5 indicates that the single-crystal of the lithium nickel manganese oxide powder substantially belongs to the crystal system with {111} crystal planes. In some embodiments, the XRD pattern of the lithium nickel manganese oxide powder shows that the strongest diffraction peak (i.e., the peak with the highest intensity) is at the second diffraction position 22. In some embodiments, the first intensity at the first diffraction position 21 is less than the third intensity at the third diffraction position 23, where the third diffraction position 23 corresponds to the (311) crystal plane, with a 2θ value between 35.5° and 37.5°, for example, 35.5°, 36°, 36.5°, 37°, or 37.5°.

In some embodiments, the lithium nickel manganese oxide powder particles are separated without agglomeration, contributing to uniformity among the particles, such as the particle size span described above. The particle size span reflects the degree of uniformity in particle size, where a smaller span indicates higher consistency in particle size. In some embodiments, the particle size span of the lithium nickel manganese oxide powder is less than 5, for example, less than 4, less than 3, less than 2, or less than 1. In some embodiments, the particle size span of the lithium nickel manganese oxide powder is greater than 0. In some embodiments, the particle size span is preferably between 0.7 and 2, for example, 0.7, 1.0, 1.5, or 2. The particle size span (D₉₀-D₁₀)/D₅₀ can be obtained from the particle size distribution chart, where D₁₀, D₅₀, and D₉₀ represent the particle size positions in the particle size distribution chart where 10%, 50%, and 90% of the total powder quantity have particle sizes smaller than D₁₀, D₅₀, and D₉₀. For example, if D₁₀ is a specific value, it indicates that 10% of the total powder quantity has a particle size smaller than this specific value. The values of D₁₀, D₅₀, and D₉₀ are also associated with the desired particle size of the powder. However, regardless of the specific particle size, the present disclosure ensures that (D₉₀-D₁₀)/D₅₀ has a notably small value as described above, indicating a high degree of particle size uniformity. In some embodiments, the present disclosure's D₁₀ is in the range of 0.5 µm to 4.5 µm (for example, 0.5 µm, 1.5 µm, 2.5 µm, 3.5 µm, or 4.5 µm), D₅₀ is in the range of 2 µm to 8 µm (for example, 2 µm, 4 µm, 6 µm, or 8 µm), and D₉₀ is in the range of 5.5 µm to 8.5 µm (for example, 5.5 µm, 6.5 µm, 7.5 µm, or 8.5 µm). In some embodiments, the present disclosure's D₉₉ (i.e., the particle size at which 99% of the total powder is smaller than the D₉₉ value) is less than 15 µm, for example, less than 10 µm. In some embodiments, the present disclosure's powder particle size is in the range of 0.5 µm to 15 µm (for example, 0.5 µm, 2 µm, 5 µm, 8 µm, 10 µm, 12 µm, or 15 µm). In some embodiments, the particle size of the lithium nickel manganese oxide powder is preferably in the range of 1 µm to 10 µm (for example, 1 µm, 2.5 µm, 5 µm, 7.5 µm, or 10 µm).

The present disclosure also provides a lithium-ion battery including the above-described lithium nickel manganese oxide powder. The lithium-ion battery includes a cathode, an anode, and an electrolyte located between the cathode and the anode, in which the cathode includes a metal electrode and the lithium nickel manganese oxide powder disposed on the metal electrode. The lithium-ion battery of the present disclosure exhibits excellent properties, such as a high discharge plateau, high capacity, high coulombic efficiency, and high capacity retention over extended use. The following describes the lithium-ion battery of the present disclosure in detail based on some embodiments.

In some embodiments, the metal electrode of the cathode can be made of any suitable material, such as aluminum. In some embodiments, the cathode further includes a conductive material and a binder disposed on the metal electrode, and the cathode can be formed by mixing the lithium nickel manganese oxide powder, conductive material, and binder to create a mixture and then coating the mixture onto the metal electrode. The conductive material enhances conductivity, while the binder not only provides adhesion but also offers additional functionalities depending on the material chosen. In some embodiments, the lithium nickel manganese oxide powder, conductive material, and binder can be mixed in any suitable solvent, such as N-methyl-2-pyrrolidone (NMP), in which the solids content of the mixture and solvent solution is preferably between 42% and 55%, for example, 42%, 45%, 47%, 50%, 52%, or 55%. In some embodiments, the lithium nickel manganese oxide powder accounts for at least 80% of the total weight of the lithium nickel manganese oxide powder, conductive material, and binder, for example, at least 85%. In some embodiments, when the metal electrode contains a conductive material and a binder, the conductive material accounts for 1.5% to 10% of the total weight of the lithium nickel manganese oxide powder, conductive material, and binder, for example, 1.5%, 2%, 4%, 6%, 8%, or 10%, and the binder accounts for 2% to 12% of the total weight of the lithium nickel manganese oxide powder, conductive material, and binder, for example, 2%, 4%, 6%, 8%, 10%, or 12%. In some embodiments, preferred conductive materials include carbon black, and preferred binders include polyvinylidene fluoride (PVDF). In some embodiments, the anode includes any suitable material, such as graphite. In some embodiments, the electrolyte can be any suitable electrolyte solution, such as ethylene carbonate, dimethyl carbonate, diethyl carbonate containing lithium salts, or their analogs or combinations; or any suitable solid electrolyte, such as ceramic materials based on lithium metal oxides.

The good properties of the lithium-ion battery disclosed herein are described in detail. The lithium-ion battery has a high discharge potential, providing stable discharge over a long period of time, for example, with a discharge potential ranging from 4.5 V to 4.9 V, such as 4.5 V, 4.6 V, 4.7 V, 4.8 V, or 4.9 V. The lithium-ion battery also has a high charge-discharge capacity, such as at least greater than 135 mAh/g, and an initial coulombic efficiency of at least greater than 85%. The lithium-ion battery can maintain a high capacity retention rate even after long-term charge-discharge cycling, for example, maintaining at least 98% of its capacity after 500 cycles.

The present disclosure also provides a precursor material for the cathode material of the aforementioned battery. The precursor material can be formed into the cathode material of the battery through the methods and/or devices provided below. The precursor material includes a powder (referred to as lithium nickel manganese oxide precursor powder) that can be used to form lithium nickel manganese oxide. Specifically, the lithium nickel manganese oxide precursor powder is a mixture that includes uniformly mixed lithium source, nickel source, and manganese source. The particle size of the lithium nickel manganese oxide precursor powder is uniform, non-agglomerated, and substantially corresponds to the particle size, particle size distribution, particle size span, D₁₀, D₅₀, D₉₀, and D₉₉ of the lithium nickel manganese oxide powder described above. As a result, the lithium nickel manganese oxide precursor powder can be directly converted into lithium nickel manganese oxide powder with the corresponding particle size by heating through the methods described below.

For example, in some embodiments, the D₅₀ of the lithium nickel manganese oxide precursor powder is in the range of 2 µm to 8 µm, such as 2 µm, 4 µm, 6 µm, or 8 µm. In some embodiments, the particle size span of the lithium nickel manganese oxide precursor powder is at least smaller than 5, for example, smaller than 4, smaller than 3, smaller than 2, or smaller than 1; and in some embodiments, the particle size span of the lithium nickel manganese oxide precursor powder is greater than 0. In some embodiments, the particle size span of the lithium nickel manganese oxide precursor powder is preferably in the range of 0.7 to 2, such as 0.7, 1.0, 1.5, or 2. For example, in some embodiments, the particle size of the lithium nickel manganese oxide precursor powder is preferably in the range of 1 µm to 10 µm, such as 1 µm, 2.5 µm, 5 µm, 7.5 µm, or 10 µm. Furthermore, in some embodiments, the lithium nickel manganese oxide precursor powder is spherical in shape.

In some embodiments, the lithium source includes Li₂CO₃, LiNO₃, Li₂C₂O₄, LiOH, or combinations thereof; the nickel source includes NiCO₃, Ni(NO₃)₂, NiC₂O₄, Ni(OH)₂, or combinations thereof; and the manganese source includes MnCO₃, MnOOH, MnO₂, or combinations thereof. In some embodiments, the lithium nickel manganese oxide precursor powder further includes selectively doped compounds containing Al, Ti, Zr, Cr, Fe, Nb, or Sb. In some embodiments, the molar ratios of lithium from the lithium source, nickel from the nickel source, manganese from the manganese source, and Al, Ti, Zr, Cr, Fe, Nb, or Sb from the doped compounds in the lithium nickel manganese oxide precursor powder are in the range of 0.99-1.10:0.40-0.50:1.4-1.6:0-0.1, to enable the composition of the resulting lithium nickel manganese oxide powder to correspond to the formula LiₓNi_{y}AzMn₂₋y₋zO₄ described above.

In some embodiments, the particle size of the lithium source, nickel source, and manganese source is independently in the range of 100 nm to 1500 nm, such as 100 nm, 250 nm, 500 nm, 750 nm, 1000 nm, 1250 nm, or 1500 nm. In some embodiments, the particle size span of the lithium source, nickel source, and manganese source is independently in the range of 1.0 to 2.5, such as 1.0, 1.25, 1.5, 1.75, 2, 2.25, or 2.5.

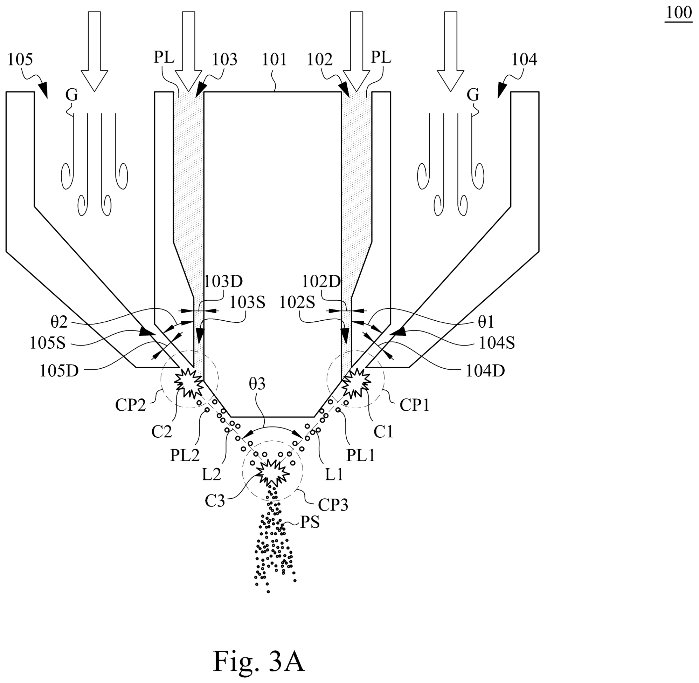

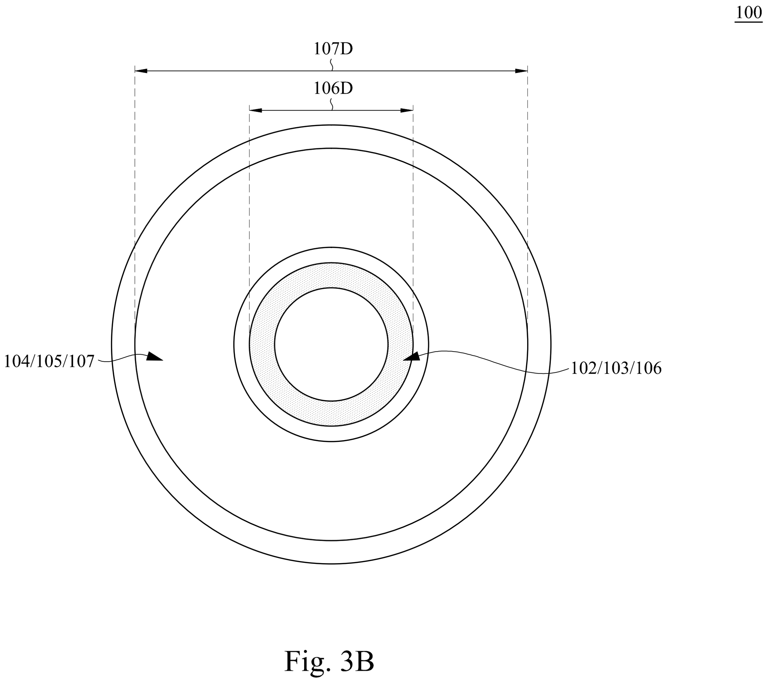

The present disclosure also provides an apparatus for manufacturing the aforementioned cathode material for batteries. The apparatus includes a particle size controller (also referred to as an atomizer) and a heater. The particle size controller includes a heating element, a first liquid flow channel and a second liquid flow channel configured to allow the lithium nickel manganese oxide precursor liquid to flow in, as well as a first gas flow channel and a second gas flow channel configured to allow gas to flow in. The first liquid nozzle of the first liquid flow channel is configured to intersect the first gas nozzle of the first gas flow channel at a first angle, enabling the collision between the lithium nickel manganese oxide precursor liquid and the gas to form the first lithium nickel manganese oxide precursor droplets. Similarly, the second liquid nozzle of the second liquid flow channel is configured to intersect the second gas nozzle of the second gas flow channel at a second angle, enabling the collision between the lithium nickel manganese oxide precursor liquid and the gas to form the second lithium nickel manganese oxide precursor droplets. Additionally, the extension line of the first gas nozzle is configured to intersect the extension line of the second gas nozzle at a third angle, and the heating element is configured to provide a heating temperature at the third angle, enabling the collision and drying of the first and second lithium nickel manganese oxide precursor droplets at the third angle to form lithium nickel manganese oxide precursor powder. The heater is configured to convert the lithium nickel manganese oxide precursor powder into lithium nickel manganese oxide powder, in which the crystalline structure of the powder is single-crystal, the particle size span is less than 5, and the particle size span is defined as (D₉₀-D₁₀)/D₅₀. Using the apparatus of the present disclosure, high-quality lithium nickel manganese oxide precursor powder and lithium nickel manganese oxide powder can be manufactured, ultimately resulting in high-performance lithium-ion batteries. For details regarding the lithium nickel manganese oxide precursor powder, lithium nickel manganese oxide powder, and lithium-ion batteries, please refer to the aforementioned descriptions, which will not be repeated here. The following sections detail the apparatus based on some embodiments with reference to Figs. 3A and 3B.

As shown in Figs. 3A and 3B, the apparatus 100 includes a particle size controller 101 and a heater (not separately illustrated) for crystal growth. The particle size controller 101 converts the lithium nickel manganese oxide precursor liquid PL flowing into it into lithium nickel manganese oxide precursor powder PS with desired properties, such as specific particle size, uniform particle distribution, and non-agglomeration. The heater further converts the precursor powder PS into agglomeration-free single-crystal powder with a corresponding particle size and uniformity (i.e., the lithium nickel manganese oxide powder described above).

The details of the particle size controller 101 are as follows. The particle size controller 101 includes a first liquid flow channel 102, a second liquid flow channel 103, a first gas flow channel 104, and a second gas flow channel 105. The lithium nickel manganese oxide precursor liquid PL (indicated schematically with dotted shading and arrows in the figures) enters the first liquid flow channel 102 and the second liquid flow channel 103, while gas G (indicated schematically with wave-like symbols and arrows) enters the first gas flow channel 104 and the second gas flow channel 105. In the particle size controller 101, the first liquid nozzle 102S of the first liquid flow channel 102 intersects with the first gas nozzle 104S of the first gas flow channel 104 at the first intersection point CP1 (indicated by a dashed circular frame in the figures). This allows the lithium nickel manganese oxide precursor liquid PL sprayed from the first liquid nozzle 102S to collide with the gas G sprayed from the first gas nozzle 104S at CP1, undergoing the first collision C1 to form the first lithium nickel manganese oxide precursor droplets PL1. In some embodiments, the first angle 01 (i.e., the collision angle between the lithium nickel manganese oxide precursor liquid PL and the gas G) is preferably between 55° and 70°, such as 55°, 60°, 65°, or 70°. Similarly, in the particle size controller 101, the second liquid nozzle 103S of the second liquid flow channel 103 intersects with the second gas nozzle 105S of the second gas flow channel 105 at the second intersection point CP2 (also indicated by a dashed circular frame in the figures). This enables the lithium nickel manganese oxide precursor liquid PL sprayed from the second liquid nozzle 103S to collide with the gas G sprayed from the second gas nozzle 105S at CP2, undergoing the second collision C2 to form the second lithium nickel manganese oxide precursor droplets PL2. In some embodiments, the second angle θ2 (i.e., the collision angle between the lithium nickel manganese oxide precursor liquid PL and the gas G) is also preferably between 55° and 70°, such as 55°, 60°, 65°, or 70°. The first precursor droplets PL1 and the second precursor droplets PL2 formed through the above collisions are then carried by the gas G sprayed from the first gas nozzle 104S and the second gas nozzle 105S, respectively, to the third intersection point CP3 in the particle size controller 101 (indicated by a dashed circular frame in the figures). At the third intersection point CP3, they undergo a third collision C3 and are dried by the heating element, forming lithium nickel manganese oxide precursor powder PS. Specifically, the third intersection point CP3 is located at the intersection of the first extension line L1 of the first gas nozzle 104S and the second extension line L2 of the second gas nozzle 105S, with the first lithium nickel manganese oxide precursor droplets PL1 and the second lithium nickel manganese oxide precursor droplets PL2 traveling along L1 and L2, respectively, to the third intersection point CP3. In some embodiments, the third angle θ3 (i.e., the collision angle between the first lithium nickel manganese oxide precursor droplets PL1 and the second lithium nickel manganese oxide precursor droplets PL2) is preferably between 110° and 140°, such as 110°, 120°, 130°, or 140°.

In some embodiments, the third intersection CP3 is positioned below and between the first intersection CP1 and the second intersection CP2. In some embodiments, the third angle θ3 is substantially twice the first angle θ1 and the second angle θ2, respectively. In some embodiments, the first gas nozzle 104S and the second gas nozzle 105S are located outside the particle size controller 101 relative to the first liquid nozzle 102S and the second liquid nozzle 103S. In some embodiments, the diameters 102D and 103D of the first liquid nozzle 102S and the second liquid nozzle 103S, respectively, are independently 0.4 mm to 0.6 mm, such as 0.4 mm, 0.5 mm, or 0.6 mm. Additionally, the diameters 104D and 105D of the first gas nozzle 104S and the second gas nozzle 105S, respectively, are independently 0.3 mm to 0.5 mm, such as 0.3 mm, 0.4 mm, or 0.5 mm. In some embodiments, the first liquid flow channel 102 and the second liquid flow channel 103 are connected and include a first circular connection section 106 in a top view. Similarly, the first gas flow channel 104 and the second gas flow channel 105 are connected and include a second circular connection section 107 in a top view. This configuration simplifies the implementation and design requirements of the particle size controller 101. In some embodiments, the diameter 107D of the second circular connection section 107 is larger than the diameter 106D of the first circular connection section 106, and the center of the first circular connection section 106 is substantially aligned with the center of the second circular connection section 107. In some embodiments, the particle size controller 101 further includes heating elements (not shown) configured to provide heating temperatures at the first intersection CP1, the second intersection CP2, and the third intersection CP3. This configuration allows effective drying of the lithium nickel manganese oxide precursor liquid PL, the first lithium nickel manganese oxide precursor droplets PL1, and the second lithium nickel manganese oxide precursor droplets PL2, not only through the energy generated by the gas G and collisions but also by the heating elements. In some embodiments, the heating elements can be a single unit or multiple units, which can heat the first intersection CP1, the second intersection CP2, and the third intersection CP3 simultaneously or independently.

The heater is now described. The heater is configured to convert the lithium nickel manganese oxide precursor powder PS into lithium nickel manganese oxide powder. In some embodiments, the heater may include any feasible device that provides heating temperatures for crystal growth (e.g., a high-temperature furnace). The heater may be directly connected to the particle size controller 101 to perform heating near the third intersection CP3 of the particle size controller 101, or it may be separate, collecting the lithium nickel manganese oxide precursor powder PS produced by the particle size controller 101 into the separate heater for heating.

The apparatus 100 disclosed herein can produce high-quality lithium nickel manganese oxide precursor powder and lithium nickel manganese oxide powder with a simple setup. For example, the apparatus 100 disclosed herein may essentially exclude grinding-related devices and may essentially exclude organic chelating agents and precipitants.

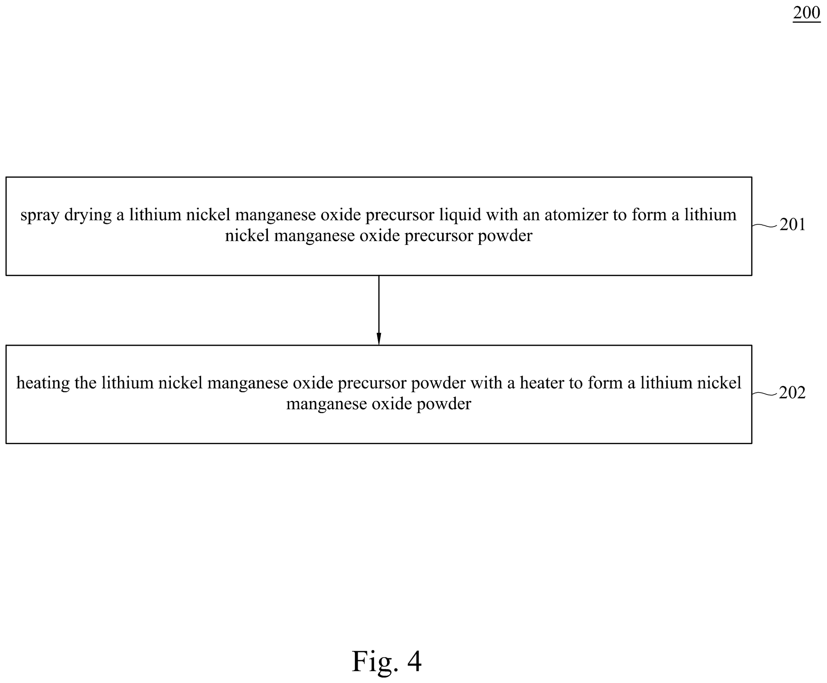

The present disclosure also provides a method for producing the cathode material described above, which includes the following steps. The lithium nickel manganese oxide precursor liquid is sprayed and dried using an atomizer to form lithium nickel manganese oxide precursor powder. When the atomizer is the particle size controller described above, the method includes introducing the lithium nickel manganese oxide precursor liquid into the first liquid flow channel and the second liquid flow channel of the particle size controller and introducing gas into the first gas flow channel and the second gas flow channel of the particle size controller. This setup converts the lithium nickel manganese oxide precursor liquid into the first lithium nickel manganese oxide precursor droplets through the first collision, and into the second lithium nickel manganese oxide precursor droplets through the second collision. The first and second lithium nickel manganese oxide precursor droplets are then converted into lithium nickel manganese oxide precursor powder through a third collision and the heating temperature provided by heating elements. The lithium nickel manganese oxide precursor powder is subsequently heated using a heater to form lithium nickel manganese oxide powder, in which the crystal structure of the lithium nickel manganese oxide powder is single-crystal, the particle size span of the lithium nickel manganese oxide powder is less than 5, and the particle size span is defined as (D₉₀-D₁₀)/D₅₀ in the particle size distribution. The method disclosed herein enables the production of high-quality lithium nickel manganese oxide precursor powder and lithium nickel manganese oxide powder, further yielding high-performance lithium-ion batteries. Detailed descriptions of the lithium nickel manganese oxide precursor powder, lithium nickel manganese oxide powder, lithium-ion batteries, and apparatus can be found in the sections above, and thus are not repeated here. Additionally, the method disclosed herein does not require the use of organic chelating agents or precipitants. The following sections describe the method disclosed herein in detail, according to some embodiments and with reference to Fig. 4, supplemented by Figs. 3A and 3B.

In operation 201 of method 200, the lithium nickel manganese oxide precursor liquid is spray-dried using an atomizer to form lithium nickel manganese oxide precursor powder. For example, the particle size controller 101 of apparatus 100 converts the lithium nickel manganese oxide precursor liquid (PL) into lithium nickel manganese oxide precursor powder (PS). In some embodiments, the lithium nickel manganese oxide precursor liquid is a water-based liquid, making it easy to implement. In some embodiments, the precursor liquid contains a lithium source, a nickel source, a manganese source, water, and optionally doped compounds containing Al, Ti, Zr, Cr, Fe, Nb, or Sb. The stoichiometric ratios of the lithium, nickel, manganese, and optional dopants in these compounds are adjusted according to the desired composition of the final product LiₓNi_{y}A_{z}Mn_{2-y-z}O₄, where x, y, z, and 2-y-z are stoichiometric parameters. For instance, the molar ratios of lithium in the lithium source, nickel in the nickel source, manganese in the manganese source, and Al, Ti, Zr, Cr, Fe, Nb, or Sb in the doped compounds in the precursor liquid are 0.99-1.10: 0.40-0.50: 1.4-1.6: 0-0.1. In some embodiments, the lithium source may include Li₂CO₃, LiNO₃, Li₂C₂O₄, LiOH, or their combinations; the nickel source may include NiCO₃, Ni(NO₃)₂, NiC₂O₄, Ni(OH)₂, or their combinations; and the manganese source may include MnCO₃, MnOOH, MnO₂, or their combinations. In some embodiments, the particle sizes of the lithium source, nickel source, and manganese source are each independently 100 nm to 1500 nm, such as 100 nm, 250 nm, 500 nm, 750 nm, 1000 nm, 1250 nm, or 1500 nm. Additionally, the particle size span of each source is independently 1.0 to 2.5, such as 1.0, 1.25, 1.5, 1.75, 2.0, 2.25, or 2.5. In some embodiments, the method further includes grinding the precursor materials of the lithium, nickel, and manganese sources before operation 201 to form the lithium, nickel, and manganese sources with the aforementioned particle sizes and spans for use in the precursor liquid. The preferred grinding time is 4.5 to 6.5 hours, such as 4.5 hours, 5.5 hours, or 6.5 hours. It should be noted that operation 201 of this disclosure, as well as operation 202 described below, do not require grinding-related steps, as the desired particle size of the lithium nickel manganese oxide precursor powder and lithium nickel manganese oxide powder can primarily be controlled through operation 201 (as detailed later). In some embodiments, the solid content of the lithium nickel manganese oxide precursor liquid is preferably 18 wt% to 40 wt%, such as 18 wt%, 23 wt%, 27 wt%, 32 wt%, 37 wt%, or 40 wt%. The apparent density of the precursor liquid is preferably 1.1 g/cm³ to 1.6 g/cm³, such as 1.1 g/cm³, 1.2 g/cm³, 1.4 g/cm³, or 1.6 g/cm³. In some embodiments, the precursor liquid may further include fluxes such as KCl, LiCl, NaCl, Na₂SO₄, or their combinations to facilitate the heating process in operation 202. These fluxes also help improve the grain size of the single crystals formed in operation 202.

Operation 201 is described as follows. In some embodiments, when the lithium nickel manganese oxide precursor liquid is spray-dried using an atomizer, the precursor liquid collides with a gas inside the atomizer. The gas can include air or oxygen, for example, an oxygen-enriched atmosphere, and the preferred gas pressure ranges from 300 kPa to 360 kPa, such as 300 kPa, 320 kPa, 340 kPa, or 360 kPa. In some embodiments, when the lithium nickel manganese oxide precursor liquid is spray-dried using the atomizer, the liquid is dried at a temperature ranging from 100°C to 250°C. For example, in the particle size controller 101 of device 100, the gas G and the precursor liquid PL undergo a first collision C1 and a second collision C2, forming first precursor droplets PL1 and second precursor droplets PL2, respectively. The composition of the first precursor droplets PL1 and the second precursor droplets PL2 is substantially identical to that of the precursor liquid PL. However, the first precursor droplets PL1 and the second precursor droplets PL2 exist as separate droplets. The first collision C1 and second collision C2 occur at a first temperature and a second temperature, respectively, for example, controlled by heating elements as previously described. The first and second temperatures independently range from 100°C to 250°C, such as 100°C, 130°C, 170°C, 220°C, or 250°C, and may be the same or different. For instance, in the particle size controller 101 of device 100, the first precursor droplets PL1 and the second precursor droplets PL2 undergo a third collision C3 and are exposed to heat provided by a heating element, forming lithium nickel manganese oxide precursor powder PS. The composition of the lithium nickel manganese oxide precursor powder PS is similar to that of the precursor liquid PL, but the moisture content in the lithium nickel manganese oxide precursor powder PS is substantially removed. The particle size of the lithium nickel manganese oxide precursor powder PS is smaller than that of the first precursor droplets PL1 and the second precursor droplets PL2. The third collision C3 occurs at a third temperature, for example, controlled by the heating element, which ranges from 100°C to 250°C, such as 100°C, 130°C, 170°C, 220°C, or 250°C. The third temperature can be the same as or different from the first and second temperatures. In some embodiments, after the third collision C3 is completed, the lithium nickel manganese oxide precursor powder PS retains energy and exhibits a temperature ranging from 80°C to 110°C, such as 80°C, 90°C, 100°C, or 110°C.

After completing operation 201, in operation 202 of method 200, the lithium nickel manganese oxide precursor powder is heated using a heater (e.g., the heater of apparatus 100) to form the lithium nickel manganese oxide powder disclosed herein. In some embodiments, after the lithium nickel manganese oxide precursor powder enters the heater, the heater heats the powder at a rate of +2 °C/min to +7 °C/min (e.g., +2 °C/min, +5 °C/min, or +7 °C/min) to a temperature between 800°C and 1100°C (e.g., 800°C, 900°C, 1000°C, or 1100°C), maintaining that temperature for 8 hours to 16 hours (e.g., 8 hours, 10 hours, 12 hours, 14 hours, or 16 hours) to form the lithium nickel manganese oxide powder. In some embodiments, the particle size of the lithium nickel manganese oxide powder may have a proportional relationship with the heating temperature mentioned above. In some embodiments, forming the lithium nickel manganese oxide powder by heating the lithium nickel manganese oxide precursor powder requires only a single continuous heating process without the need for multiple separate heating steps. Furthermore, in some embodiments, the heating of the lithium nickel manganese oxide precursor powder to form the lithium nickel manganese oxide powder is performed in an air or oxygen-rich environment (e.g., enriched oxygen).

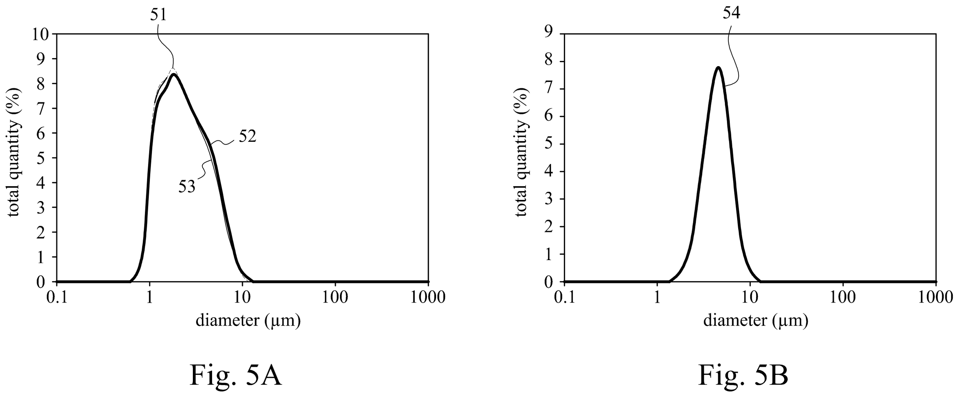

In fact, the particle size of the lithium nickel manganese oxide precursor powder and the lithium nickel manganese oxide powder is primarily determined by operation 201. For example, the particle size of the lithium nickel manganese oxide precursor powder and the lithium nickel manganese oxide powder are inversely proportional to the flow rate ratio of the gas to the lithium nickel manganese oxide precursor liquid (i.e., the gas flow rate divided by the flow rate of the lithium nickel manganese oxide precursor liquid). This allows the desired particle size of the lithium nickel manganese oxide precursor powder and the lithium nickel manganese oxide powder to be adjusted by varying the flow rate ratio (e.g., an average particle size of approximately 2.53 µm can be obtained when the flow rate ratio is 9000, and an average particle size of approximately 4.35 µm can be obtained when the flow rate ratio is 6000). In some embodiments, the preferable flow rate ratio of the gas to the lithium nickel manganese oxide precursor liquid is between 3000 and 10000, such as 3000, 4500, 6000, 7500, 9000, or 10000. Furthermore, since the lithium nickel manganese oxide powder is formed from the lithium nickel manganese oxide precursor powder (e.g., one lithium nickel manganese oxide precursor powder particle forms one lithium nickel manganese oxide powder particle), it can be understood that the particle size distribution (e.g., particle size span) of the lithium nickel manganese oxide precursor powder essentially corresponds to the particle size distribution (e.g., particle size span) of the lithium nickel manganese oxide powder. To illustrate the inverse relationship, Figs. 5A and 5B show the particle size distribution of lithium nickel manganese oxide precursor powder according to some embodiments. Fig. 5A includes three particle size distribution curves (curves 51, 52, and 53) obtained by performing the same operation with a flow rate ratio set to 9000, while Fig. 5B includes a particle size distribution curve (curve 54) obtained by performing the same operation with a flow rate ratio set to 6000. As shown in Figs. 5A and 5B, the overlap among the curves is significant (in Fig. 5B, curve 54 overlaps almost as a single line). Additionally, the average particle size span of the curves in Fig. 5A is 1.86, while the average particle size span of the curve in Fig. 5B is 0.92.

Next, detailed embodiments are provided to illustrate the present disclosure. It should be noted that the following embodiments are intended to help those skilled in the art better understand the present disclosure and are not intended to limit the scope of the present disclosure.

Referring to Table 1, a comparison of the first embodiment, second embodiment, and first comparative example shows that when the method of the present disclosure further includes grinding the precursor materials of the lithium source, nickel source, and manganese source before performing operation 201, the effect of grinding time on the particle size and particle size span of the lithium source, nickel source, and manganese source is as shown in Table 1.

**Table 1**

| | D₁₀ | D₅₀ | D₉₀ | particle size span |
|---|---|---|---|---|
| First Comparative Example (Grinding for 4 hours) | 160 nm | 390 nm | 1540 nm | 3.54 |
| First Embodiment (Grinding for 5 hours) | 140 nm | 280 nm | 510 nm | 1.32 |
| Second Embodiment (Grinding for 6 hours) | 140 nm | 280 nm | 550 nm | 1.46 |

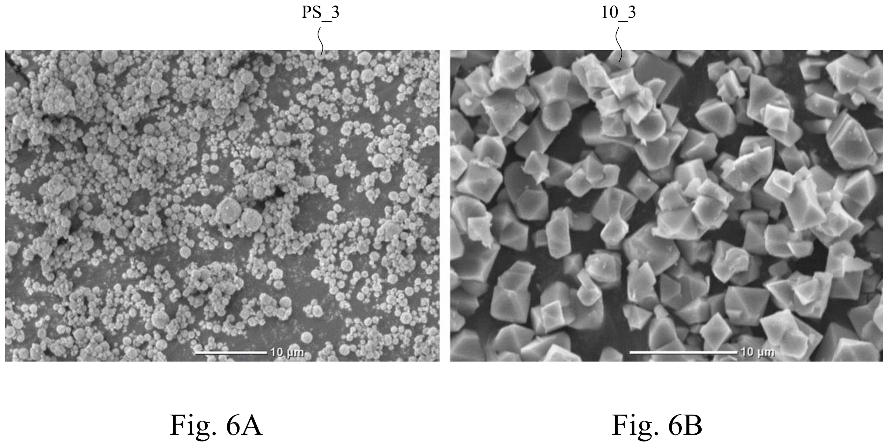

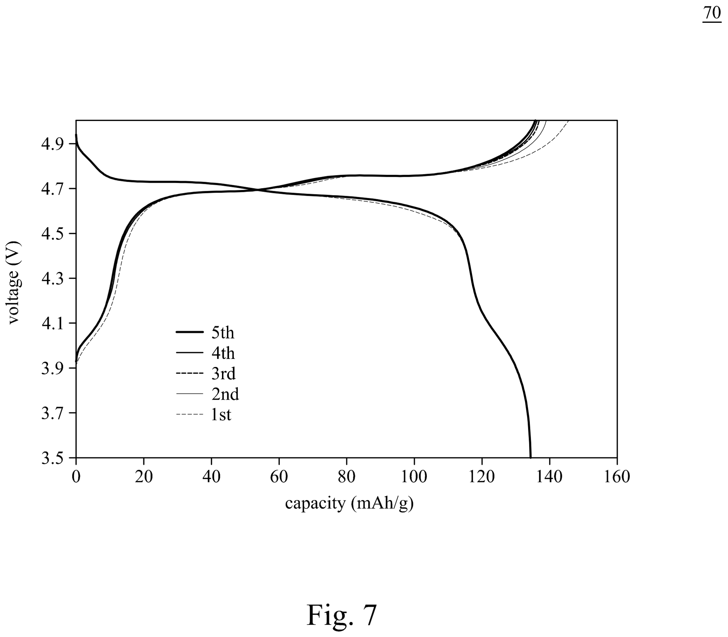

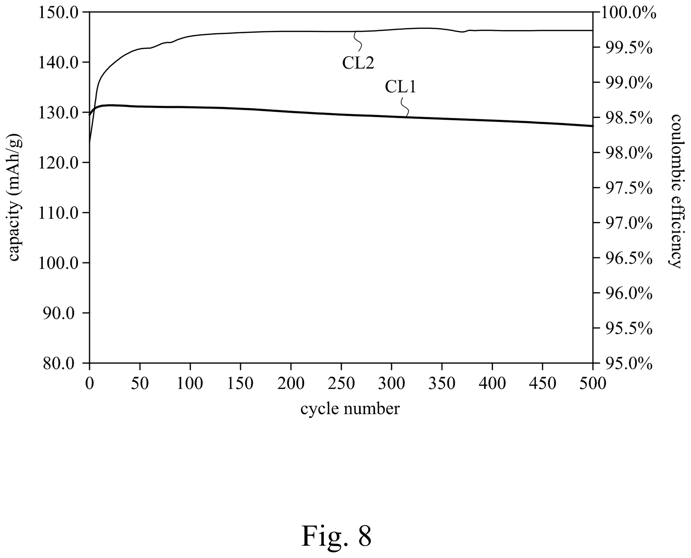

In the third embodiment (refer to Figs. 6A to 8), the lithium source is Li₂CO₃, the nickel source is Ni(NO₃)₂, the manganese source is a combination of MnCO₃ and MnOOH, and the doped element is chromium (Cr). Li_{1.08}Ni_{0.425}Cr_{0.05}Mn_{1.525}O₄ is formed using the apparatus and method of the present disclosure. The flow ratio of the gas to the lithium nickel manganese oxide precursor liquid in the particle size controller is about 9000, resulting in a lithium nickel manganese oxide precursor powder PS_3 with a D₅₀ of approximately 2 µm, as shown in Fig. 6A. The lithium nickel manganese oxide precursor powder is then introduced into a heater, where it is heated at a rate of +5 °C/min from room temperature to 1000 °C and held at this temperature for 12 hours in an air atmosphere, forming the lithium nickel manganese oxide powder 10_3, as shown in Fig. 6B. The lithium nickel manganese oxide powder is then mixed with carbon black and polyvinylidene fluoride (PVDF) in N-methyl-2-pyrrolidone and coated onto a 10 µm to 15 µm thick aluminum current collector. The weight ratio of lithium nickel manganese oxide powder, carbon black, and PVDF is 86:6:8. The mixture coated on the aluminum current collector is then dried and made into a positive electrode for a lithium-ion battery with a 12 mm diameter, with a negative electrode paired with a lithium metal foil. After charge-discharge conditioning of the lithium-ion battery between 3.5 V and 5 V at 0.2 C, the charge-discharge capacity exceeds 135 mAh/g, and the initial Coulombic efficiency is greater than 85%, as shown in the voltage versus capacity change graph 70 in Fig. 7. In Fig. 7, the charge-discharge capacity and coulombic efficiency after 1, 2, 3, 4, and 5 cycles (corresponding to the curves labeled as 1st, 2nd, 3rd, 4th, and 5th in the graph) are summarized in Table 2. As seen in Fig. 7, the lithium-ion battery not only exhibits good charge-discharge capacity and coulombic efficiency but also shows high reproducibility in initial charge-discharge performance. Fig. 8 shows the capacity versus cycle number graph (corresponding to the curve CL1) and the coulombic efficiency versus cycle number graph (corresponding to the curve CL2) of the lithium-ion battery during charge-discharge cycling at 0.5 C charge and 1 C discharge at room temperature. From Fig. 8, it can be seen that after 500 charge-discharge cycles, the capacity retention of the lithium-ion battery reaches 98.2%.

**Table 2**

| Charge and Discharge Cycle Number | Charge Capacity (mAh/g) | Discharge Capacity (mAh/g) | Coulombic Efficiency (%) |
|---|---|---|---|
| 1 | 157.8 | 136.5 | 86.5 |
| 2 | 149.8 | 136.6 | 91.2 |
| 3 | 145.9 | 136.0 | 93.3 |
| 4 | 144.9 | 136.0 | 93.8 |
| 5 | 144.6 | 136.0 | 94.1 |

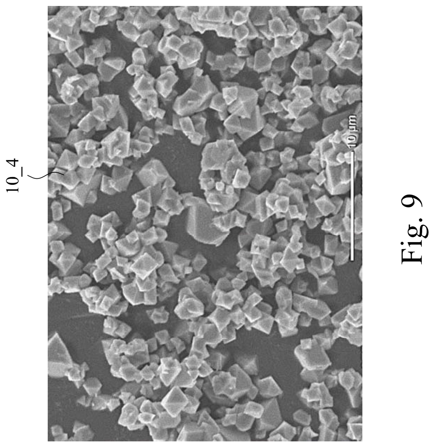

The fourth embodiment (referencing Fig. 9) is similar to the third embodiment, so detailed explanation is omitted. However, in the fourth embodiment, the lithium nickel manganese oxide precursor powder is heated in the heater to 950°C and maintained at that temperature for 10 hours to form the lithium nickel manganese oxide powder 10_4, as shown in Fig. 9. By comparing Fig. 6B and Fig. 9, it can be observed that when the heating temperature for forming the lithium nickel manganese oxide powder is lower, the resulting lithium nickel manganese oxide powder may also have a smaller particle size.

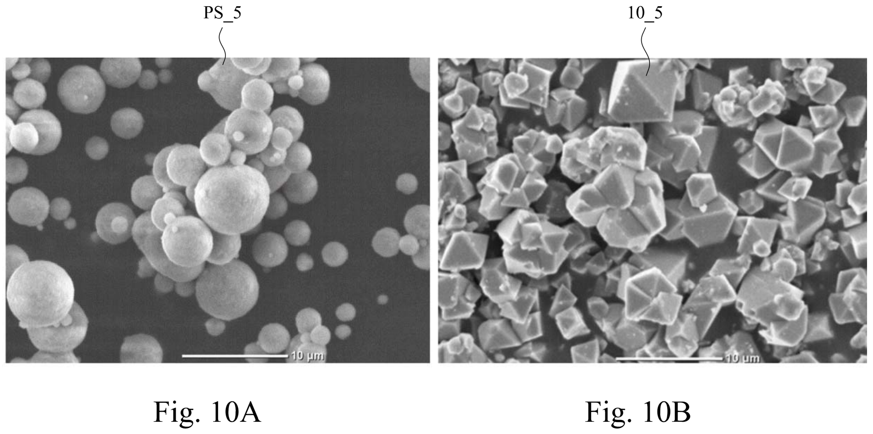

In the fifth embodiment (referencing Fig. 10A to Fig. 10B), the lithium source is Li₂CO₃, the nickel source is Ni(NO₃)₂, the manganese source is a combination of MnCO₃ and MnOOH, and the dopant element is iron (Fe). The lithium nickel manganese oxide powder Li1_{.08}Ni_{0.425}Fe_{0.05}Mn_{1.525}O₄ is formed using the apparatus and method disclosed herein. The gas-to-lithium nickel manganese oxide precursor liquid flow ratio in the particle size controller is about 3000, resulting in the lithium nickel manganese oxide precursor powder PS_5 shown in Fig. 10A. Then, the lithium nickel manganese oxide precursor powder is placed in the heater and heated in an air environment at a rate of +5 °C/min from room temperature to 1000 °C, followed by a 12-hour holding period to form the lithium nickel manganese oxide powder 10_5, as shown in Fig. 10B.

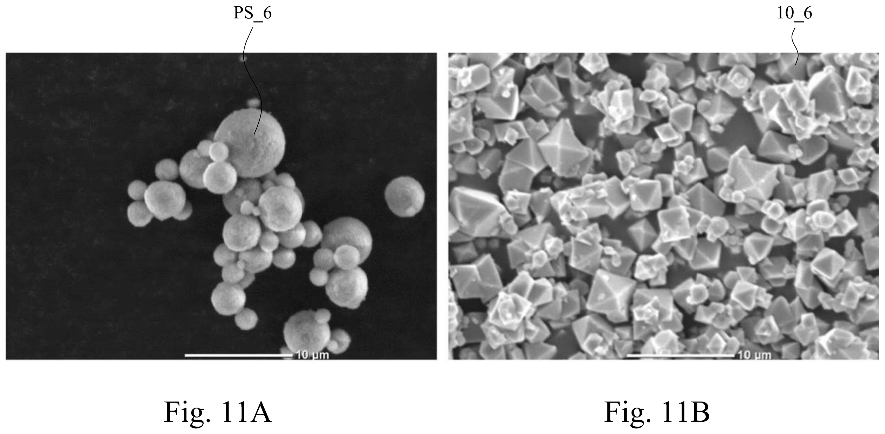

The sixth embodiment (referencing Fig. 11A to Fig. 11B) is similar to the fifth embodiment, and thus, further details are not reiterated. However, in the sixth embodiment, the gas-to-lithium nickel manganese oxide precursor liquid flow ratio is about 6000, resulting in the lithium nickel manganese oxide precursor powder PS_6 shown in Fig. 11A and the lithium nickel manganese oxide powder 10_6 shown in Fig. 11B. A comparison between Fig. 11A to Fig. 11B and Fig. 10A to Fig. 10B reveals that as the gas-to-lithium nickel manganese oxide precursor liquid flow ratio increases, the resulting lithium nickel manganese oxide powder's particle size decreases (i.e., an inverse relationship).

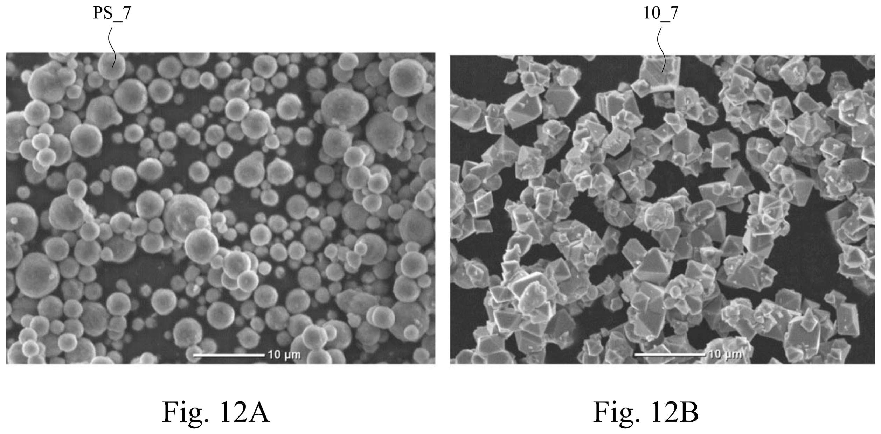

In the seventh embodiment (referencing Fig. 12A to Fig. 12B), the lithium source is Li₂CO₃, the nickel source is Ni(NO₃)₂, the manganese source is MnO₂, and the dopant element is titanium (Ti). The lithium nickel manganese oxide powder Li_{1.08}Ni_{0.425}Ti_{0.05}Mn_{1.525}O₄ is formed using the apparatus and method disclosed in the present disclosure. The gas-to-lithium nickel manganese oxide precursor liquid flow ratio in the particle size controller is about 6000, resulting in the lithium nickel manganese oxide precursor powder PS_7 with an average particle size of about 5 µm, as shown in Fig. 12A. The lithium nickel manganese oxide precursor powder is then placed in a heater and heated in an air environment at a rate of +5 °C/min from room temperature to 1000 °C, followed by holding the temperature for 12 hours to form the lithium nickel manganese oxide powder 10_7, as shown in Fig. 12B.

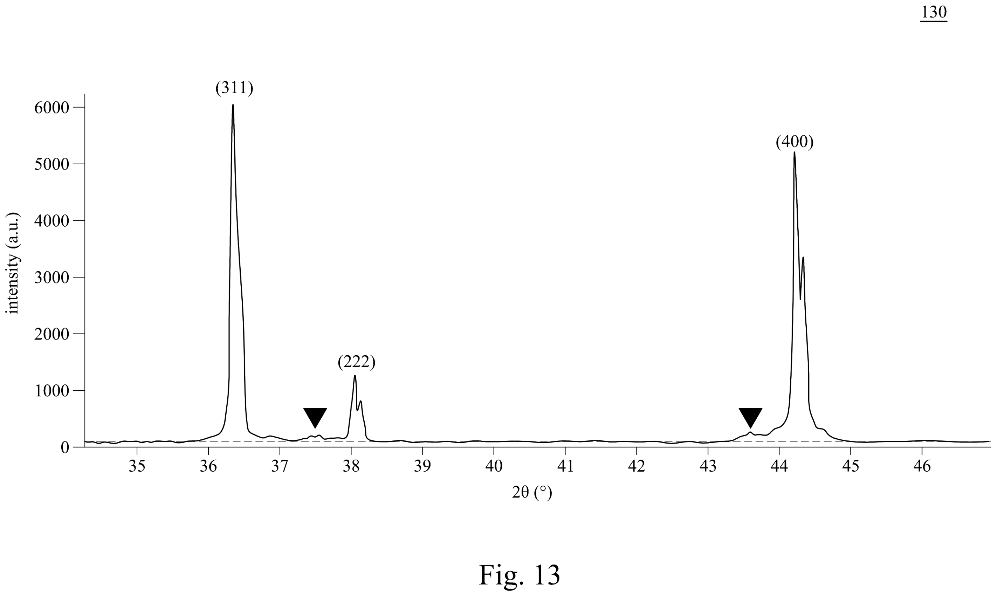

In the second comparative example (referencing Fig. 13), when a commercially available (nickel, manganese) hydrous oxide is mixed with lithium hydroxide to produce a lithium nickel manganese oxide powder similar to that disclosed in the present disclosure, the lithium content in the crystal may be significantly deficient, as shown in the X-ray powder diffraction spectrum using Cu-Kα in Fig. 13. Additionally, the secondary phase of nickel manganese oxide can also be seen in the X-ray diffraction spectrum 130 of Fig. 13, at the 20 values of 37.478° and 43.550°, indicated by the ▼ symbol.

The lithium nickel manganese oxide precursor powder and lithium nickel manganese oxide powder disclosed in the present disclosure exhibit excellent quality, such as high purity, stable single-crystal structure, and minimal particle size distribution with no aggregation or separation between the lithium nickel manganese oxide precursor powder and lithium nickel manganese oxide powder. As a result, the lithium-ion batteries produced from the present disclosure also demonstrate outstanding properties, such as a high discharge platform, high capacity, high coulombic efficiency, and long-term high capacity retention. Furthermore, the apparatus and methods for manufacturing the lithium nickel manganese oxide precursor powder and lithium nickel manganese oxide powder disclosed in the present disclosure are simple (for example, the lithium nickel manganese oxide powder is formed by a single heating process), and the required particle size of the lithium nickel manganese oxide precursor powder and lithium nickel manganese oxide powder can be easily controlled to meet the expected stoichiometry, significantly reducing manufacturing costs. Additionally, the present disclosure eliminates the need for cobalt, reduces the heating temperature, and does not require processes related to washing, making it more environmentally friendly and sustainable.

## Claims

1. A battery cathode material, **characterized by** comprising:
a lithium nickel manganese oxide powder, wherein a crystal structure of the lithium nickel manganese oxide powder is a single crystal, the single crystal of the lithium nickel manganese oxide powder is a cubic crystal system with a {111} crystal plane and has an octahedral shape, a particle size span of the lithium nickel manganese oxide powder is less than 5, and the particle size span is (D₉₀-D₁₀)/D₅₀ from a particle size distribution.

2. The battery cathode material of claim 1, **characterized in that** a particle size of the lithium nickel manganese oxide powder is from 0.5 µm to 15 µm.

3. The battery cathode material of any one of claims 1 to 2, **characterized in that** in an X-ray diffraction pattern of the lithium nickel manganese oxide powder, a ratio of a first intensity at a first diffraction position to a second intensity at a second diffraction position is less than 0.5, the first diffraction position has a 2θ value from 41° to 47°, and the second diffraction position has a 20 value from 15° to 22°.

4. The battery cathode material of claim 3, **characterized in that** in the X-ray diffraction pattern of the lithium nickel manganese oxide powder, the first intensity at the first diffraction position is less than a third intensity at a third diffraction position, and the third diffraction position has a 20 value from 35.5° to 37.5°.

5. The battery cathode material of any one of claims 1 to 4, **characterized in that** the lithium nickel manganese oxide powder is LiₓNi_{y}A_{z}Mn_{2-y-z}O₄, where A is Al, Ti, Zr, Cr, Fe, Nb, or Sb, x is from 0.99 to 1.10, y is from 0.40 to 0.50, and z is from 0 to 0.1.

6. A lithium-ion battery, **characterized by** comprising:
a cathode comprising a metal electrode and the lithium nickel manganese oxide powder of claim 1, wherein the lithium nickel manganese oxide powder is disposed on the metal electrode;
an anode; and
an electrolyte disposed between the cathode and the anode.

7. A precursor of a battery cathode material, **characterized by** comprising:
a lithium nickel manganese oxide precursor powder, wherein the lithium nickel manganese oxide precursor powder comprises a mixture of a lithium source, a nickel source, and a manganese source, a particle size span of the lithium nickel manganese oxide precursor powder is less than 5, and the particle size span is (D₉₀-D₁₀)/D₅₀ from a particle size distribution.

8. The precursor of claim 7, **characterized in that** a particle size of the lithium nickel manganese oxide precursor powder is from 1 µm to 10 µm.

9. The precursor of any one of claims 7 and 8, **characterized in that** the D₅₀ is from 2 µm to 8 µm.

10. The precursor of any one of claims 7 to 9, **characterized in that** a molar ratio of lithium from the lithium source, nickel from the nickel source, and manganese from the manganese source in the lithium nickel manganese oxide precursor powder is from 0.99-1.10:0.40-0.50:1.4-1.6.

11. The precursor of any one of claims 7 to 10, **characterized in that** a particle size span of the lithium source is from 1.0 to 2.5, a particle size span of the nickel source is from 1.0 to 2.5, and a particle size span of the manganese source is from 1.0 to 2.5.

12. A method for manufacturing a battery cathode material, **characterized by** comprising:
spray drying a lithium nickel manganese oxide precursor liquid with an atomizer to form a lithium nickel manganese oxide precursor powder; and
heating the lithium nickel manganese oxide precursor powder with a heater to form a lithium nickel manganese oxide powder, wherein a crystal structure of the lithium nickel manganese oxide powder is a single crystal, a particle size span of the lithium nickel manganese oxide powder is less than 5, and the particle size span is (D₉₀-D₁₀)/D₅₀ from a particle size distribution.

13. The method of claim 12, **characterized in that** the lithium nickel manganese oxide precursor liquid comprises a lithium source, a nickel source, a manganese source, and water, a solid content of the lithium nickel manganese oxide precursor liquid is from 18 wt% to 40 wt%, and an apparent density of the lithium nickel manganese oxide precursor liquid is from 1.1 g/cm³ to 1.6 g/cm³.

14. The method of any one of claims 12 to 13, **characterized in that** during the spray drying of the lithium nickel manganese oxide precursor liquid with the atomizer, the lithium nickel manganese oxide precursor liquid collides with a gas in the atomizer, a particle size of the lithium nickel manganese oxide powder is inversely proportional to a flow rate ratio of the gas to the lithium nickel manganese oxide precursor liquid, and the flow rate ratio of the gas to the lithium nickel manganese oxide precursor liquid is from 3000 to 10000.

15. The method of any one of claims 12 to 14, **characterized in that** during the spray drying of the lithium nickel manganese oxide precursor liquid with the atomizer, the lithium nickel manganese oxide precursor liquid is dried at a temperature from 100°C to 250°C, and during the heating of the lithium nickel manganese oxide precursor powder, the lithium nickel manganese oxide precursor powder is heated at a temperature from 800°C to 1100°C for a duration from 8 hours to 16 hours.
